# EUROPEAN PATENT APPLICATION

(11) **EP 4 622 101 A1**
(43) Date of publication of application: **24.09.2025**
(21) Application number: 23891089.7
(22) Date of filing: 10.07.2023
(51) Int. Cl.: H03F 3/45, H03F 1/22, H03F 1/32, H03F 3/21

(54) **POWER AMPLIFICATION DEVICE**

(30) Priority: 15.11.2022 JP 2022182623
(71) Applicant: Fujikura Ltd., Tokyo 135-8512 (JP)
(72) Inventor: YAMAGUCHI Yuichiro, Sakura-shi, Chiba 285-8550 (JP)
(74) Representative: Lavoix
(86) International application number: PCT/JP2023/025445
(87) International publication number: WO 2024/105927

(57) **Abstract**

A power amplification device includes a differential amplification circuit in which a plurality of transistors are connected in cascode connection in multi stages, in which feedback is performed from each output of at least one stage of the stages of the differential amplification circuit to an initial-stage input on a same-phase side.

## Description

### TECHNICAL FIELD

The present invention relates to a power amplification device.

Priority is claimed on Japanese Patent Application No. 2022-182623, filed November 15, 2022, the content of which is incorporated herein by reference.

### BACKGROUND ART

Patent Document 1 discloses a power amplification circuit in which a line having an inductance value for improving linearity (reducing distortion) is disposed. **In** addition, Patent Document 2 discloses a differential amplification circuit in which feedback circuits are crossed.

### Citation List

### Patent Documents

Patent Document 1: Japanese Unexamined Patent Application, First Publication No. 2021-77939
Patent Document 2: Japanese Unexamined Patent Application, First Publication No. 2005-12770

### SUMMARY OF INVENTION

### Technical Problem

Meanwhile, in a technology of Patent Document 1, in order to obtain a large inductance value, it is necessary to dispose a large-sized line, and there is a problem that an increase in circuit area cannot be avoided. On the other hand, in a technology of Patent Document 2, isolation of the feedback circuits is improved and linearity is also improved, but there is a problem that a degree of improvement is small and desired linearity cannot be obtained.

The present invention has been made in view of the above circumstances, and an object of the present invention is to provide a power amplification device capable of improving linearity while avoiding an increase in circuit area.

### Solution to Problem

In order to achieve the aforementioned objects, Aspect 1 of the present invention is a power amplification device comprising a differential amplification circuit in which a plurality of transistors are connected in cascode connection in multi stages, in which feedback is performed from each output of at least one stage of the stages of the differential amplification circuit to an initial-stage input on a same-phase side.

Aspect 2 of the present invention is the power amplification device according to Aspect 1, in which the at least one stage is an initial stage.

Aspect 3 of the present invention is the power amplification device according to Aspect 1, in which the at least one stage is all stages.

Aspect 4 of the present invention is the power amplification device according to any one of Aspects 1 to 3, in which the feedback is performed using a capacitor.

Aspect 5 of the present invention is the power amplification device according to Aspect 4, in which the multi stages are two stages, the at least one stage is all stages, an electrostatic capacitance of the capacitor that connects an output of a second stage and an input of a first stage is larger than an electrostatic capacitance of the capacitor that connects an output of the first stage and the input of the first stage.

### Advantageous Effects of Invention

According to the above-described aspects of the present invention, it is possible to provide a power amplification device capable of improving linearity while avoiding an increase in circuit area.

### BRIEF DESCRIPTION OF DRAWINGS

[FIG. 1] A circuit diagram showing the configuration of a power amplification device according to a first embodiment of the present invention.
[FIG. 2] A table showing straightness of the power amplification device according to the first embodiment of the present invention.
[FIG. 3] A circuit diagram showing the configuration of a power amplification device according to a second embodiment of the present invention.

### DESCRIPTION OF EMBODIMENTS

Hereinafter, embodiments of the present invention will be described with reference to the drawings.

### [First Embodiment]

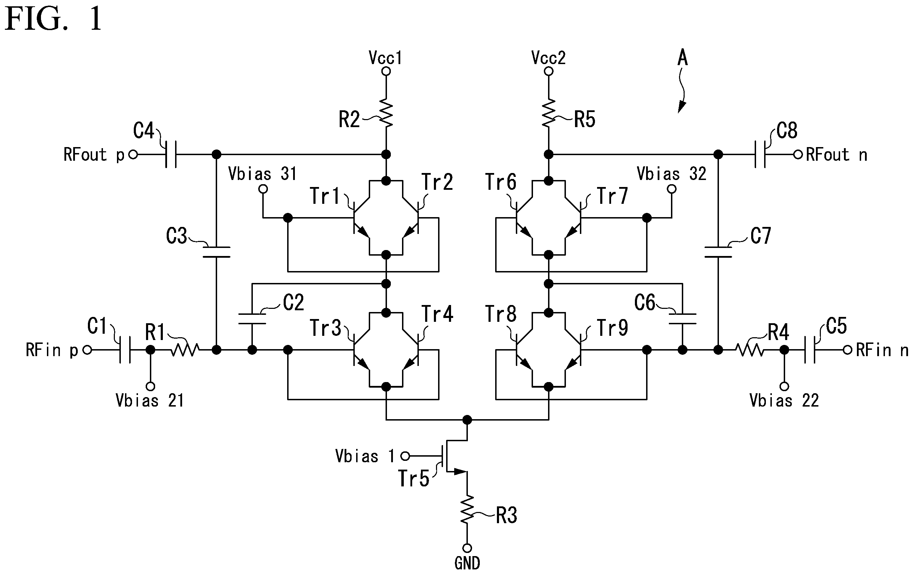

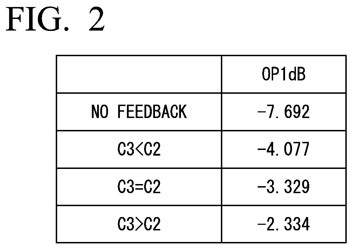

First, a first embodiment of the present invention will be described with reference to FIGS. 1 and 2. As shown in FIG. 1, a power amplification device A according to the first embodiment includes nine transistors Tr1 to Tr9, five resistors R1 to R5, eight capacitors C1 to C8, a pair of power supply terminals Vcc1 and Vcc2, a ground terminal GND, a pair of high-frequency input terminals RFin p and RFin n, a pair of high-frequency output terminals RFout p and RFout n, and five bias terminals Vbias1, Vbias21, Vbias22, Vbias31, and Vbias32.

The first transistor Tr1 is an NPN type bipolar transistor as shown in the drawing, and a collector terminal thereof is connected to a collector terminal of the second transistor Tr2, a first end of the second resistor R2, a first end of the third capacitor C3, and a first end of the fourth capacitor C4. In addition, an emitter terminal of the first transistor Tr1 is connected to an emitter terminal of the second transistor Tr2, a first end of the second capacitor C2, a collector terminal of the third transistor Tr3, and a collector terminal of the fourth transistor Tr4. Further, a base terminal of the first transistor Tr1 is connected to the fourth bias terminal Vbias31.

The second transistor Tr2 is an NPN type bipolar transistor as shown in the drawing, and the collector terminal thereof is connected to the collector terminal of the first transistor Tr1, the first end of the second resistor R2, the first end of the third capacitor C3, and the first end of the fourth capacitor C4. In addition, the emitter terminal of the second transistor Tr2 is connected to the emitter terminal of the first transistor Tr1, the first end of the second capacitor C2, the collector terminal of the third transistor Tr3, and the collector terminal of the fourth transistor Tr4. Further, in the second transistor Tr2, a base terminal is connected to the base terminal of the first transistor Tr1 and the fourth bias terminal Vbias31.

The third transistor Tr3 is an NPN type bipolar transistor as shown in the drawing, and the collector terminal thereof is connected to the emitter terminal of the first transistor Tr1, the emitter terminal of the second transistor Tr2, the collector terminal of the fourth transistor Tr4, and the first end of the second capacitor C2. In addition, an emitter terminal of the third transistor Tr3 is connected to an emitter terminal of the fourth transistor Tr4, a drain terminal of the fifth transistor Tr5, an emitter terminal of the eighth transistor Tr8, and an emitter terminal of the ninth transistor Tr9. Further, a base terminal of the third transistor Tr3 is connected to a base terminal of the fourth transistor Tr4, a second end of the second capacitor C2, a second end of the third capacitor C3, and a first end of the first resistor R1.

The fourth transistor Tr4 is an NPN type bipolar transistor as shown in the drawing, and the collector terminal thereof is connected to the emitter terminal of the first transistor Tr1, the emitter terminal of the second transistor Tr2, the collector terminal of the third transistor Tr3, and the first end of the second capacitor C2. In addition, the emitter terminal of the fourth transistor Tr4 is connected to the emitter terminal of the third transistor Tr3, the drain terminal of the fifth transistor Tr5, the emitter terminal of the eighth transistor Tr8, and the emitter terminal of the ninth transistor Tr9. Further, the base terminal of the fourth transistor Tr4 is connected to the base terminal of the third transistor Tr3, the second end of the second capacitor C2, the second end of the third capacitor C3, and the first end of the first resistor R1.

The fifth transistor Tr5 is a MOS type field-effect transistor as shown in the drawing, and the drain terminal thereof is connected to the emitter terminal of the third transistor Tr3, the emitter terminal of the fourth transistor Tr4, the emitter terminal of the eighth transistor Tr8, and the emitter terminal of the ninth transistor Tr9. In addition, a source terminal of the fifth transistor Tr5 is connected to a first end of the third resistor R3. Further, a gate terminal of the fifth transistor Tr5 is connected to the first bias terminal Vbias1.

The sixth transistor Tr6 is an NPN type bipolar transistor as shown in the drawing, and a collector terminal thereof is connected to a collector terminal of the seventh transistor Tr7, a first end of the fifth resistor R5, a first end of the seventh capacitor C7, and a first end of the eighth capacitor C8. **In** addition, an emitter terminal of the sixth transistor Tr6 is connected to an emitter terminal of the seventh transistor Tr7, a first end of the sixth capacitor C6, a collector terminal of the eighth transistor Tr8, and a collector terminal of the ninth transistor Tr9. Further, a base terminal of the sixth transistor Tr6 is connected to a base terminal of the seventh transistor Tr7 and the fifth bias terminal Vbias32.

The seventh transistor Tr7 is an NPN type bipolar transistor as shown in the drawing, and the collector terminal thereof is connected to the collector terminal of the sixth transistor Tr6, the first end of the fifth resistor R5, the first end of the seventh capacitor C7, and the first end of the eighth capacitor C8. **In** addition, the emitter terminal of the seventh transistor Tr7 is connected to the emitter terminal of the sixth transistor Tr6, the first end of the sixth capacitor C6, the collector terminal of the eighth transistor Tr8, and the collector terminal of the ninth transistor Tr9. Further, the base terminal of the seventh transistor Tr7 is connected to the base terminal of the sixth transistor Tr6 and the fifth bias terminal Vbias32.

The eighth transistor Tr8 is an NPN type bipolar transistor as shown in the drawing, and the collector terminal thereof is connected to the emitter terminal of the sixth transistor Tr6, the emitter terminal of the seventh transistor Tr7, the collector terminal of the ninth transistor Tr9, and the first end of the sixth capacitor C6. In addition, the emitter terminal of the eighth transistor Tr8 is connected to the emitter terminal of the ninth transistor Tr9, the drain terminal of the fifth transistor Tr5, the emitter terminal of the third transistor Tr3, and the emitter terminal of the fourth transistor Tr4. Further, a base terminal of the eighth transistor Tr8 is connected to a base terminal of the ninth transistor Tr9, the second end of the sixth capacitor C6, the second end of the seventh capacitor C7, and a first end of the fourth resistor R4.

The ninth transistor Tr9 is an NPN type bipolar transistor as shown in the drawing, and the collector terminal thereof is connected to the emitter terminal of the sixth transistor Tr6, the emitter terminal of the seventh transistor Tr7, the collector terminal of the eighth transistor Tr8, and the first end of the sixth capacitor C6. In addition, the emitter terminal of the ninth transistor Tr9 is connected to the emitter terminal of the eighth transistor Tr8, the drain terminal of the fifth transistor Tr5, the emitter terminal of the third transistor Tr3, and the emitter terminal of the fourth transistor Tr4. Further, the base terminal of the ninth transistor Tr9 is connected to the base terminal of the eighth transistor Tr8, the second end of the sixth capacitor C6, the second end of the seventh capacitor C7, and the first end of the fourth resistor R4.

The first resistor R1 has a predetermined resistance value (first resistance value), and the first end thereof is connected to the base terminal of the third transistor Tr3, the base terminal of the fourth transistor Tr4, the second end of the second capacitor C2, and the second end of the third capacitor C3. In addition, the second end of the first resistor R1 is connected to first end of the first capacitor C1 and the second bias terminal Vbias21.

The second resistor R2 has a predetermined resistance value (second resistance value), and the first end thereof is connected to the collector terminal of the first transistor Tr1, the collector terminal of the second transistor Tr2, the first end of the third capacitor C3, and the first end of the fourth capacitor C4. In addition, the second end of the second resistor R2 is connected to the first power supply terminal Vcc1.

The third resistor R3 has a predetermined resistance value (third resistance value), and the first end thereof is connected to the source terminal of the fifth transistor Tr5. In addition, the second end of the third resistor R3 is connected to the ground terminal GND.

The fourth resistor R4 has a predetermined resistance value (fourth resistance value), and the first end thereof is connected to the base terminal of the eighth transistor Tr8, the base terminal of the ninth transistor Tr9, the second end of the sixth capacitor C6, and the second end of the seventh capacitor C7. In addition, the second end of the fourth resistor R4 is connected to the third bias terminal Vbias22 and the first end of the fifth capacitor C5.

The fifth resistor R5 has a predetermined resistance value (fifth resistance value), and the first end thereof is connected to the collector terminal of the sixth transistor Tr6, the collector terminal of the seventh transistor Tr7, the first end of the seventh capacitor C7, and the first end of the eighth capacitor C8. In addition, the second end of the fifth resistor R5 is connected to the second power supply terminal Vcc2.

The first capacitor C1 has a predetermined electrostatic capacitance (first electrostatic capacitance), and the first end thereof is connected to the second end of the first resistor R1 and the second bias terminal Vbias21. In addition, the second end of the first capacitor C1 is connected to the first high-frequency input terminal RFin p.

The second capacitor C2 has a predetermined electrostatic capacitance (second electrostatic capacitance), and the first end thereof is connected to the emitter terminal of the first transistor Tr1, the emitter terminal of the second transistor Tr2, the collector terminal of the third transistor Tr3, and the collector terminal of the fourth transistor Tr4. In addition, the second end of the second capacitor C2 is connected to the base terminal of the third transistor Tr3, the base terminal of the fourth transistor Tr4, the first end of the first resistor R1, and the second end of the third capacitor C3.

The third capacitor C3 has a predetermined electrostatic capacitance (third electrostatic capacitance), and the first end thereof is connected to the collector terminal of the first transistor Tr1, the collector terminal of the second transistor Tr2, the first end of the second resistor R2, and the first end of the fourth capacitor C4. In addition, the second end of the third capacitor C3 is connected to the base terminal of the third transistor Tr3, the base terminal of the fourth transistor Tr4, the first end of the first resistor R1, and the second end of the second capacitor C2.

The fourth capacitor C4 has a predetermined electrostatic capacitance (fourth electrostatic capacitance), and the first end thereof is connected to the collector terminal of the first transistor Tr1, the collector terminal of the second transistor Tr2, the first end of the second resistor R2, and the first end of the third capacitor C3. In addition, the second end of the fourth capacitor C4 is connected to the first high-frequency output terminal RFout p.

The fifth capacitor C5 has a predetermined electrostatic capacitance (fifth electrostatic capacitance), and the first end thereof is connected to the second end of the fourth resistor R4 and the third bias terminal Vbias22. In addition, the second end of the fifth capacitor C5 is connected to the second high-frequency input terminal RFin n.

The sixth capacitor C6 has a predetermined electrostatic capacitance (sixth electrostatic capacitance), and the first end thereof is connected to the emitter terminal of the sixth transistor Tr6, the emitter terminal of the seventh transistor Tr7, the collector terminal of the eighth transistor Tr8, and the collector terminal of the ninth transistor Tr9. In addition, the second end of the sixth capacitor C6 is connected to the base terminal of the eighth transistor Tr8, the base terminal of the ninth transistor Tr9, the first end of the fourth resistor R4, and the second end of the seventh capacitor C7.

The seventh capacitor C7 has a predetermined electrostatic capacitance (seventh electrostatic capacitance), and the first end thereof is connected to the collector terminal of the sixth transistor Tr6, the collector terminal of the seventh transistor Tr7, the first end of the fifth resistor R5, and the first end of the eighth capacitor C8. In addition, the second end of the seventh capacitor C7 is connected to the base terminal of the eighth transistor Tr8, the base terminal of the ninth transistor Tr9, the first end of the fourth resistor R4, and the second end of the sixth capacitor C6.

The eighth capacitor C8 has a predetermined electrostatic capacitance (eighth electrostatic capacitance), and the first end thereof is connected to the collector terminal of the sixth transistor Tr6, the collector terminal of the seventh transistor Tr7, the first end of the fifth resistor R5, and the first end of the seventh capacitor C7. **In** addition, the second end of the eighth capacitor C8 is connected to the second high-frequency output terminal RFout n.

The first power supply terminal Vcc1 is connected to the second end of the second resistor R2. The first power supply terminal Vcc1 is connected to a direct current voltage power supply having a predetermined power supply voltage outside. The second power supply terminal Vcc2 is connected to the second end of the fifth resistor R5. The second power supply terminal Vcc2 is connected to a direct current voltage power supply outside. In addition, the ground terminal GND is connected to the second end of the third resistor R3. The ground terminal GND is grounded outside.

The first high-frequency input terminal RFin p is connected to the second end of the first capacitor C1. A first high-frequency signal is input from an outside to the first high-frequency input terminal RFin p. The second high-frequency input terminal RFin n is connected to the second end of the fifth capacitor C5. A second high-frequency signal is input from the outside to the second high-frequency input terminal RFin n.

The first high-frequency output terminal RFout p is connected to the second end of the fourth capacitor C4. The first high-frequency output terminal RFout p is one of a pair of output ends in the power amplification device A, and outputs a first high-frequency amplified signal obtained by power-amplifying the first high-frequency signal by a predetermined multiple to the outside.

The second high-frequency output terminal RFout n is connected to the second end of the eighth capacitor C8. The second high-frequency output terminal RFout n is the other of the pair of output ends in the power amplification device A, and outputs a second high-frequency amplified signal obtained by power-amplifying the second high-frequency signal by a predetermined multiple to the outside.

The first bias terminal Vbias1 is connected to the gate terminal of the fifth transistor Tr5. A predetermined first bias voltage is applied to the first bias terminal Vbias1 from an external bias circuit. The first bias voltage is a direct current voltage for setting a source current of the fifth transistor Tr5.

The second bias terminal Vbias21 is connected to the second end of the first resistor R1 and the first end of the first capacitor C1. A second bias voltage, which is higher than at least the first bias voltage by several volts, is applied to the second bias terminal Vbias21 from an external bias circuit. The second bias voltage is a direct current voltage for setting base bias voltages (amplification operation points) of the third transistor Tr3 and the fourth transistor Tr4.

The third bias terminal Vbias22 is connected to the second end of the fourth resistor R4 and the first end of the fifth capacitor C5. The second bias voltage is applied to the third bias terminal Vbias22 from an external bias circuit. The second bias voltage is a direct current voltage for setting base bias voltages (amplification operation points) of the eighth transistor Tr8 and the ninth transistor Tr9 to equivalent base bias voltages as the base bias voltages (amplification operation points) of the third transistor Tr3 and the fourth transistor Tr4.

The fourth bias terminal Vbias31 is commonly connected to the base terminal of the first transistor Tr1 and the base terminal of the second transistor Tr2. A third bias voltage, which is higher than at least the second bias voltage by several volts, is applied to the fourth bias terminal Vbias31 from an external bias circuit. The third bias voltage is a direct current voltage for setting base bias voltages of the first transistor Tr1 and the second transistor Tr2.

The fifth bias terminal Vbias32 is commonly connected to the base terminal of the sixth transistor Tr6 and the base terminal of the seventh transistor Tr7. The third bias voltage is applied to the fifth bias terminal Vbias32 from an external bias circuit. The third bias voltage is a direct current voltage for setting base bias voltages of the sixth transistor Tr6 and the seventh transistor Tr7 to equivalent base bias voltages as the base bias voltages of the first transistor Tr1 and the second transistor Tr2.

In the power amplification device A as above, components other than the second capacitor C2, the third capacitor C3, the sixth capacitor C6, and the seventh capacitor C7 configure a basic amplification circuit according to the present invention. That is, the power amplification device A according to the first embodiment is a power amplification device that performs feedback from an output of the basic amplification circuit to an input using the second capacitor C2, the third capacitor C3, the sixth capacitor C6, and the seventh capacitor C7.

In addition, in the power amplification device A according to the first embodiment, the first transistor Tr1 and the second transistor Tr2, the third transistor Tr3 and the fourth transistor Tr4, the sixth transistor Tr6 and the seventh transistor Tr7, and the eighth transistor Tr8 and the ninth transistor Tr9 are each connected in parallel.

The first transistor Tr1 and the second transistor Tr2, and the third transistor Tr3 and the fourth transistor Tr4 are in a well-known cascode connection relationship. In addition, the sixth transistor Tr6 and the seventh transistor Tr7, and the eighth transistor Tr8 and the ninth transistor Tr9 are also in a cascode connection relationship.

The third transistor Tr3 and the fourth transistor Tr4 configure a first stage (initial stage) on one side in cascode connection, and the first transistor Tr1 and the second transistor Tr2 configure a second stage on the one side in the cascode connection. In addition, the eighth transistor Tr8 and the ninth transistor Tr9 configure a first stage (initial stage) on the other side in the cascode connection, and the sixth transistor Tr6 and the seventh transistor Tr7 configure a second stage on the other side in the cascode connection.

In the first stage on the one side and the first stage on the other side, the emitter terminal of the third transistor Tr3 and the emitter terminal of the fourth transistor Tr4, and the emitter terminal of the eighth transistor Tr8 and the emitter terminal of the ninth transistor Tr9 are commonly connected to the drain terminal of the fifth transistor Tr5.

That is, the basic amplification circuit in the power amplification device A is a differential amplification circuit in which the first transistor Tr1 and the second transistor Tr2, and the third transistor Tr3 and the fourth transistor Tr4 are connected in the cascode connection in two stages, and the sixth transistor Tr6 and the seventh transistor Tr7, and the eighth transistor Tr8 and the ninth transistor Tr9 are connected in the cascode connection in two stages.

That is, in the power amplification device A according to the first embodiment, feedback is individually performed from outputs of all stages (the first stage and the second stage) of the cascode connection in the basic amplification circuit to an initial-stage input (first-stage input), using the second capacitor C2, the third capacitor C3, the sixth capacitor C6, and the seventh capacitor C7.

In addition, feedback from the outputs of all the stages (the first stage and the second stage) to the initial-stage input (first-stage input) is performed to an initial-stage input on a same-phase side. That is, in the power amplification device A, an output of the first stage on the one side and an input of the first stage on the one side are connected to each other via the second capacitor C2, and an output of the second stage on the one side and the input of the first stage on the one side are connected to each other via the third capacitor C3. In addition, in the power amplification device A, an output of the first stage on the other side and an input of the first stage on the other side are connected to each other via the sixth capacitor C6, and an output of the second stage on the other side and the input of the first stage on the other side are connected to each other via the seventh capacitor C7.

Next, the operation and performance of the power amplification device A according to the first embodiment configured as described above will be described in detail.

In the power amplification device A, the second capacitor C2 is provided between the base terminals (input ends) and the collector terminals (output ends) of the third transistor Tr3 and the fourth transistor Tr4, and thus functions as a first feedback capacitor. The third capacitor C3 is provided between the base terminals (input ends) of the third transistor Tr3 and the fourth transistor Tr4 and the collector terminals (output ends) of the first transistor Tr1 and the second transistor Tr2, and thus functions as a second feedback capacitor.

In addition, since the sixth capacitor C6 is provided between the base terminals (input ends) and the collector terminals (output ends) of the eighth transistor Tr8 and the ninth transistor Tr9, and thus functions as a third feedback capacitor. The seventh capacitor C7 is provided between the base terminals (input ends) of the eighth transistor Tr8 and the ninth transistor Tr9 and the collector terminals (output ends) of the sixth transistor Tr6 and the seventh transistor Tr7, and thus functions as a fourth feedback capacitor.

That is, the power amplification device A according to the first embodiment is a feedback power amplification circuit in which double feedback is performed using the second capacitor C2 and the third capacitor C3, and the sixth capacitor C6 and the seventh capacitor C7. In the power amplification device A as above, straightness of the first high-frequency amplified signal and the second high-frequency amplified signal is reduced by the double feedback as compared with a case where the feedback is not performed.

FIG. 2 is a characteristic table showing OP1dB (an output signal level in a case where the output signal level is decreased by 1dB from a linear relationship) of the power amplification device A. As shown in FIG. 2, OP1dB of the power amplification device A is improved as compared with a case where the second capacitor C2 and the third capacitor C3, and the sixth capacitor C6 and the seventh capacitor C7 are not provided (no feedback). **In** addition, OP1dB of the power amplification device A is further improved by making the electrostatic capacitance of the third capacitor C3 larger than the electrostatic capacitance of the second capacitor C2.

FIG. 2 shows OP1dB in a case where the electrostatic capacitance of the second capacitor C2 is set to be the same as the electrostatic capacitance of the sixth capacitor C6 and the electrostatic capacitance of the third capacitor C3 is set to be the same as the electrostatic capacitance of the seventh capacitor C7.

Here, a main cause of a decrease in linearity is that an output of third-order distortion increases because of the amplification of the transistor. In the power amplification device A according to the first embodiment, by providing a double feedback circuit from the outputs of all the stages using the second capacitor C2 and the third capacitor C3, and the sixth capacitor C6 and the seventh capacitor C7, it is possible to implement high linearity from a small signal to a large signal as a whole circuit and to correct the distortion of the first high-frequency amplified signal and the second high-frequency amplified signal.

Therefore, according to the present embodiment, by providing a feedback circuit including relatively small circuit elements, which are the second capacitor C2 and the third capacitor C3, and the sixth capacitor C6 and the seventh capacitor C7, it is possible to provide the power amplification device A capable of improving the linearity while avoiding an increase in circuit area.

### [Second Embodiment]

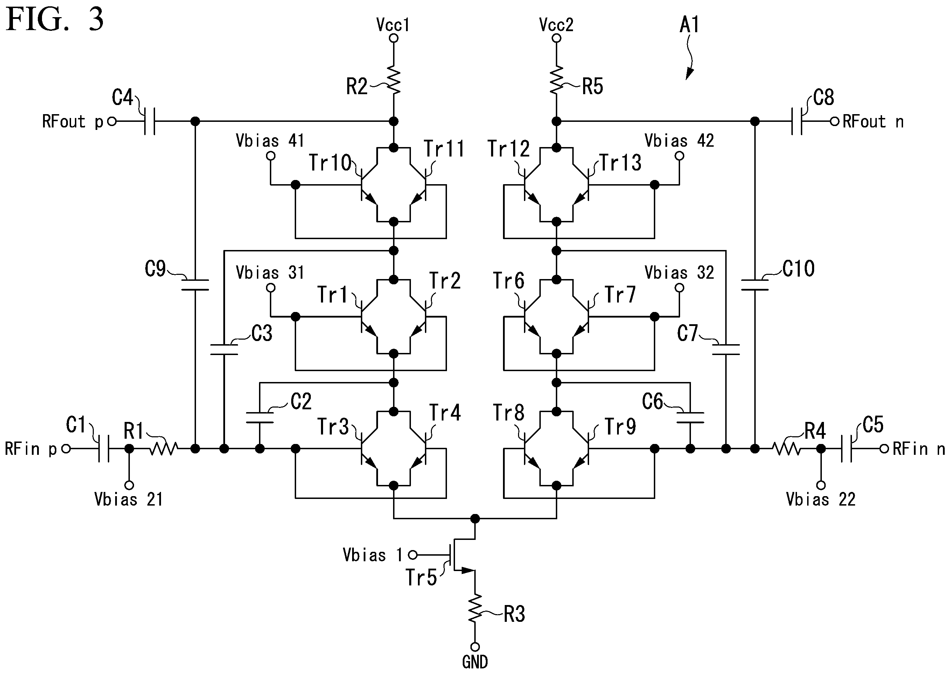

Finally, a second embodiment of the present invention will be described with reference to FIG. 3. As shown in FIG. 3, a power amplification device A1 according to the second embodiment is obtained by changing the number of stages of the cascode connection in the power amplification device A according to the first embodiment from two to three and tripling the feedback.

That is, the power amplification device A1 is a feedback power amplification circuit obtained by adding a tenth transistor Tr10, an eleventh transistor Tr11, a twelfth transistor Tr12, a thirteenth transistor Tr13, a ninth capacitor C9, a tenth capacitor C10, a sixth bias terminal Vbias41, and a seventh bias terminal Vbias42 to the power amplification device A according to the first embodiment.

An emitter terminal of the tenth transistor Tr10 is connected to the collector terminal of the first transistor Tr1, the collector terminal of the second transistor Tr2, the first end of the third capacitor C3, and an emitter terminal of the eleventh transistor Tr11. In addition, a collector terminal of the tenth transistor Tr10 is connected to a collector terminal of the eleventh transistor Tr11, the first end of the second resistor R2, the first end of the fourth capacitor C4, and first end of the ninth capacitor C9. In addition, a base terminal of the tenth transistor Tr10 is connected to a base terminal of the eleventh transistor Tr11 and the sixth bias terminal Vbias41.

The emitter terminal of the eleventh transistor Tr11 is connected to the collector terminal of the first transistor Tr1, the collector terminal of the second transistor Tr2, the first end of the third capacitor C3, and the emitter terminal of the tenth transistor Tr10. In addition, the collector terminal of the eleventh transistor Tr11 is connected to the collector terminal of the tenth transistor Tr10, the first end of the second resistor R2, the first end of the fourth capacitor C4, and the first end of the ninth capacitor C9. In addition, the base terminal of the eleventh transistor Tr11 is connected to the base terminal of the tenth transistor Tr10 and the sixth bias terminal Vbias41.

An emitter terminal of the twelfth transistor Tr12 is connected to the collector terminal of the sixth transistor Tr6, the collector terminal of the seventh transistor Tr7, the first end of the seventh capacitor C7, and an emitter terminal of the thirteenth transistor Tr13. In addition, a collector terminal of the twelfth transistor Tr12 is connected to a collector terminal of the thirteenth transistor Tr13, the first end of the fifth resistor R5, the first end of the eighth capacitor C8, and first end of the tenth capacitor C10. Further, a base terminal of the twelfth transistor Tr12 is connected to a base terminal of the thirteenth transistor Tr13 and the seventh bias terminal Vbias42.

The emitter terminal of the thirteenth transistor Tr13 is connected to the collector terminal of the sixth transistor Tr6, the collector terminal of the seventh transistor Tr7, the first end of the seventh capacitor C7, and the emitter terminal of the twelfth transistor Tr12. In addition, the collector terminal of the thirteenth transistor Tr13 is connected to the collector terminal of the twelfth transistor Tr12, the first end of the fifth resistor R5, the first end of the eighth capacitor C8, and the first end of the tenth capacitor C10. Further, the base terminal of the thirteenth transistor Tr13 is connected to the base terminal of the twelfth transistor Tr12 and the seventh bias terminal Vbias42.

The first end of the ninth capacitor C9 is connected to the collector terminal of the tenth transistor Tr10, the collector terminal of the eleventh transistor Tr11, the first end of the second resistor R2, and the first end of the fourth capacitor C4. **In** addition, the second end of the ninth capacitor C9 is connected to the base terminal of the third transistor Tr3, the base terminal of the fourth transistor Tr4, a first end of the first resistor R1, the second end of the second capacitor C2, and the second end of the third capacitor C3.

The first end of the tenth capacitor C10 is connected to the collector terminal of the twelfth transistor Tr12, the collector terminal of the thirteenth transistor Tr13, the first end of the fifth resistor R5, and the first end of the eighth capacitor C8. **In** addition, the second end of the tenth capacitor C10 is connected to the base terminal of the eighth transistor Tr8, the base terminal of the ninth transistor Tr9, the first end of the fourth resistor R4, the second end of the sixth capacitor C6, and the second end of the seventh capacitor C7.

The sixth bias terminal Vbias41 is connected to the base terminal of the tenth transistor Tr10 and the base terminal of the eleventh transistor Tr11. The seventh bias terminal Vbias42 is connected to the base terminal of the twelfth transistor Tr12 and the base terminal of the thirteenth transistor Tr13. A fourth bias voltage, which is higher than at least the third bias voltage by several volts, is applied to the sixth bias terminal Vbias41 and the seventh bias terminal Vbias42 from an external bias circuit. The fourth bias voltage is a direct current voltage for setting base bias voltages of the tenth transistor Tr10 and the eleventh transistor Tr11, and the twelfth transistor Tr12 and the thirteenth transistor Tr13.

The power amplification device A1 as above is a feedback power amplification circuit in which triple feedback is performed using the second capacitor C2, the third capacitor C3, and the ninth capacitor C9, and the sixth capacitor C6, the seventh capacitor C7, and the tenth capacitor C10. In the power amplification device A1 as above, straightness of the first high-frequency amplified signal and the second high-frequency amplified signal is reduced by the triple feedback from the outputs of all the stages as compared with a case where the feedback is not performed.

Furthermore, the present invention is not limited to the above-described embodiments, and for example, the following modifications are considered.
(1) In the first embodiment, the second capacitor C2 and the third capacitor C3, and the sixth capacitor C6 and the seventh capacitor C7, which perform feedback from each output of all the stages to the initial-stage input on the same-phase side, are provided as a feedback circuit. However, the present invention is not limited thereto. That is, it is sufficient that feedback is performed from each output of at least one stage of a differential amplification circuit in which cascode connection is made in multi stages to an initial-stage input on a same-phase side. For example, the feedback may be performed only from a first stage (initial stage) to the initial-stage input on the same-phase side.
(2) In each of the above-described embodiments, the case where the number of stages of the cascode connection is two and the case where the number of stages of the cascode connection is three have been described, but the number of stages of the cascode connection is not limited to two or three. That is, the number of stages in a case where transistors are connected in cascode connection in multiple stages to configure a differential amplification circuit may be two or more.
(3) In each of the above-described embodiments, each stage of the cascode connection is configured as a parallel connection circuit of two transistors, but the present invention is not limited thereto. That is, each stage may be configured with a single transistor, or the number of transistors connected in parallel in each stage may be three or more.

### REFERENCE SIGNS LIST

A, A1 Power amplification device
Tr1 First transistor
Tr2 Second transistor
Tr3 Third transistor
Tr4 Fourth transistor
Tr5 Fifth transistor
Tr6 Sixth transistor
Tr7 Seventh transistor
Tr8 Eighth transistor
Tr9 Ninth transistor
Tr10 Tenth transistor
Tr11 Eleventh transistor
Tr12 Twelfth transistor
Tr13 Thirteenth transistor
R1 First resistor
R2 Second resistor
R3 Third resistor
R4 Fourth resistor
R5 Fifth resistor
C1 First capacitor
C2 Second capacitor
C3 Third capacitor
C4 Fourth capacitor
C5 Fifth capacitor
C6 Sixth capacitor
C7 Seventh capacitor
C8 Eighth capacitor
C9 Ninth capacitor
C10 Tenth capacitor
Vcc1 First power supply terminal
Vcc2 Second power supply terminal
GND Ground terminal
RFin p First high-frequency input terminal
RFin n Second high-frequency input terminal
RFout p First high-frequency output terminal
RFout n Second high-frequency output terminal
Vbias1 First bias terminal
Vbias21 Second bias terminal
Vbias22 Third bias terminal
Vbias31 Fourth bias terminal
Vbias32 Fifth bias terminal
Vbias41 Sixth bias terminal
Vbias42 Seventh bias terminal

## Claims

1. A power amplification device comprising:
a differential amplification circuit in which a plurality of transistors are connected in cascode connection in multi stages,
wherein feedback is performed from each output of at least one stage of the stages of the differential amplification circuit to an initial-stage input on a same-phase side.

2. The power amplification device according to Claim 1,
wherein the at least one stage is an initial stage.

3. The power amplification device according to Claim 1,
wherein the at least one stage is all stages.

4. The power amplification device according to any one of Claims 1 to 3,
wherein the feedback is performed using a capacitor.

5. The power amplification device according to Claim 4,
wherein the multi stages are two stages, the at least one stage is all stages, an electrostatic capacitance of the capacitor that connects an output of a second stage and an input of a first stage is larger than an electrostatic capacitance of the capacitor that connects an output of the first stage and the input of the first stage.
